# EUROPEAN PATENT APPLICATION

(11) **EP 4 852 672 A1**
(43) Date of publication of application: **09.12.2026**
(21) Application number: 26166019.5
(22) Date of filing: 19.03.2026
(51) Int. Cl.: H10H 20/83, H10H 20/84, H10H 29/30, H10H 29/80

(54) **DISPLAY APPARATUS**

(30) Priority: 14.04.2025 KR 20250048135
(71) Applicant: LG Display Co., Ltd., Seoul, 07336 (KR)
(72) Inventor: SHIN, Jinhwa, 10845 Paju-si (KR); KANG, Hansaem, 10845 Paju-si (KR); CHOI, Bongseok, 10845 Paju-si (KR); KWAK, Doyoung, 10845 Paju-si (KR); JANG, Jongmin, 10845 Paju-si (KR); HWANG, Youngsuk, 10845 Paju-si (KR)
(74) Representative: Poll, Christopher

(57) **Abstract**

The present application relates to a display apparatus. A display apparatus according to one example embodiment of the present application includes a substrate, a light-emitting element disposed on the substrate, and a common connection electrode disposed on the substrate and in contact with the light-emitting element, in which the light-emitting element includes a first electrode disposed on the substrate, a light-emitting layer disposed on the first electrode, a second electrode disposed on the light-emitting layer, and a passivation film disposed on side surfaces of the light-emitting layer, and a portion of the first electrode is disposed on an outer surface of the passivation film.

## Description

### CROSS REFERENCE TO RELATED APPLICATION

The present application claims priority and benefit to Korean Patent Application No. 10-2025-0048135, filed April 14, 2025, the entire contents of which is incorporated herein for all purposes by this reference as if fully set forth herein.

### Technical Field

The present application relates to a display apparatus, and more particularly, for example, without limitation, to a display apparatus with smooth electrical connection to a light-emitting diode (LED) element.

### Description of the Related Art

As the information society develops, various demands for display apparatuses for displaying images are increasing, and various types of display apparatuses, such as a liquid crystal display (LCD) apparatus and an organic light-emitting diode (OLED) display apparatus, are being utilized.

Among the display apparatuses, there is an advantage in that the OLED display apparatus as the self-luminous type has a wider viewing angle and a higher contrast ratio, and can be lighter and thinner and has lower power consumption than the LCD apparatus because it does not require a separate backlight. In addition, there is an advantage in that the OLED display apparatus can drive at a low voltage, have a fast response time, and especially have the inexpensive manufacturing cost.

The description provided in the discussion of the related art section should not be assumed to be prior art merely because it is mentioned in or associated with that section. The discussion of the related art section may include information that describes one or more aspects of the subject technology, and the description in this section does not limit the disclosure.

### SUMMARY

The inventor has realized that in the related art, since the OLED display apparatus using organic materials are prone to defective pixels, such as oxidation between an organic light-emitting layer and electrodes due to moisture and oxygen penetration, various technical configurations are required to minimize or at least reduce such penetration.

To solve the above problems, research and development has recently been directed to display apparatuses that use light-emitting diodes (LEDs) using inorganic materials as light-emitting elements, and these light-emitting display apparatuses are attracting attention as next-generation display apparatuses because they have high image quality and high reliability.

The present application is directed to providing a display apparatus with smooth electrical connection to a light-emitting diode (LED) element.

The present application is also directed to providing a display apparatus with improved stability in a contact process with the LED element.

The present application is also directed to providing a display apparatus with improved light extraction efficiency.

The present application is also directed to providing a display apparatus that prevents or at least reduces a short circuit between a connection electrode and an active layer.

The present application is also directed to providing a display apparatus in which process efficiency is improved and process costs are reduced by separating a transfer process from an electrode connection process.

Objects of the present application are not limited to the above objects, and other technical objects may be inferred from the following embodiments. Further, it will be easily understood that the purposes and advantages according to the present disclosure may be realized using means shown in the claims or combinations thereof.

According to one example embodiment of the present application, there is provided a display apparatus including a substrate, , a light-emitting element disposed on the substrate, and a common connection electrode disposed on the substrate and in contact with the light-emitting element, wherein the light-emitting element includes a first electrode disposed on the substrate, a light-emitting layer disposed on the first electrode, a second electrode disposed on the light-emitting layer, and a passivation film disposed on side surfaces of the light-emitting layer, and a portion of the first electrode is disposed on an outer surface of the passivation film.

According to another example embodiment of the present application, there is provided a display apparatus including a substrate, an adhesive layer disposed on the substrate, a light-emitting element disposed on the adhesive layer, wherein the light-emitting element includes a first electrode disposed on the adhesive layer, a light-emitting layer disposed on the first electrode, a second electrode disposed on the light-emitting layer, and a passivation film disposed on side surfaces of the light-emitting layer, and an upper surface and side surfaces of the second electrode may be exposed.

Detailed matters of other example embodiments are included in the detailed description and accompanying drawings.

According to various example embodiments of the present application, it is possible to provide the display apparatus with smooth electrical connection with the LED element.

According to various example embodiments of the present application, it is possible to improve stability in the contact process with the LED element.

According to various example embodiments of the present application, it is possible to improve light extraction efficiency.

According to various example embodiments of the present application, it is possible to prevent or at least reduce a short circuit between the connection electrode and the active layer.

According to various example embodiments of the present application, process efficiency can be improved and process costs can be reduced by separating the transfer process from the electrode connection process.

According to various example embodiments of the present application, it is possible to improve process efficiency and reduce process costs, thereby reducing the production energy of the display apparatus.

However, effects obtainable from the present application are not limited to the above effects, and other effects that are not described will be able to be clearly understood by those skilled in the art to which the present application pertains based on the following description.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a plan view of a display apparatus according to one example embodiment.
FIG. 2 is a view illustrating a cross-sectional structure of a sub-pixel according to one example embodiment.
FIG. 3 is an enlarged view of area Q1 in FIG. 2.
FIGS. 4 to 12 are views illustrating each operation of a process of manufacturing the display apparatus according to one example embodiment.
FIG. 13 is a cross-sectional view of a display apparatus according to another example embodiment.
FIG. 14 is a cross-sectional view of a display apparatus according to still another example embodiment.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to embodiments of the present disclosure, examples of which may be illustrated in the accompanying drawings. The progression of processing steps and/or operations described is an example; however, the sequence of steps and/or operations is not limited to that set forth herein and may be changed as is known in the art, with the exception of steps and/or operations necessarily occurring in a particular order. Names of the respective elements used in the following explanations may be selected only for convenience of writing the specification and may be thus different from those used in actual products.

Hereinafter, embodiments will be described with reference to the accompanying drawings. In the specification, when a certain component (or an area, a layer, a portion, etc.) is described as "on," "connected," or "coupled to" another component, it means that the certain component may be directly connected/coupled to another component or still another component may be disposed therebetween.

The same reference numerals indicate the same components. In addition, in the drawings, thicknesses, proportions, and dimensions of components are exaggerated for effective description of technical contents. The term "and/or" includes all one or more combinations that may be defined by the associated configurations.

Terms such as "first," "second," "A" "B" "(A)" or "(B)"and the like may be used to describe various components, but the components are not limited by the terms. The terms are used only for the purpose of distinguishing one component from another. For example, a first component may be referred to as a second component, and similarly, the second component may also be referred to as the first component without departing from the scopes of various example embodiments. The singular includes the plural unless the context clearly dictates otherwise.

Terms such as "under," "at a lower side," "above," and "at an upper side" are used to describe the relationship between the components illustrated in the drawings. The terms are relative concepts and are described with respect to directions marked in the drawings.

When the position relationship is described as "on~", "over~", 'upon~', 'above~', 'below~', "beneath~" and 'next to~', one or more portions may be disposed between two other portions unless 'just' or 'direct' is used, that is, one or more other parts may be disposed located between the two parts. For example, where an element or layer is disposed "on" another element or layer, a third layer or element may be interposed therebetween.

In descriptions of temporal relationships, for example, temporal precedent relationships between two events such as "after", "subsequent to", "before", etc., another event may occur therebetween unless "directly after", "directly subsequent" or "directly before" is not indicated.

It should be understood that terms such as "includes", "has" "contain," "constitute," "make up of," "formed of," and the like are intended to specify the presence of features, numbers, steps, operations, components, parts, or a combination thereof described in the specification and does not preclude the presence or addition possibility of one or more other features, numbers, steps, operations, components, parts, or combinations thereof in advance.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning for example consistent with their meaning in the context of the relevant art and should not be interpreted in an idealized or overly formal sense unless expressly so defined herein. For example, the term "part" or "unit" may apply, for example, to a separate circuit or structure, an integrated circuit, a computational block of a circuit device, or any structure configured to perform a described function as should be understood to one of ordinary skill in the art.

The features of the various embodiments of the present disclosure may be partially or entirely combined with each other, and may be technically associated with each other or operate with each other. The embodiments may be implemented independently of each other and may be implemented together in an association relationship.

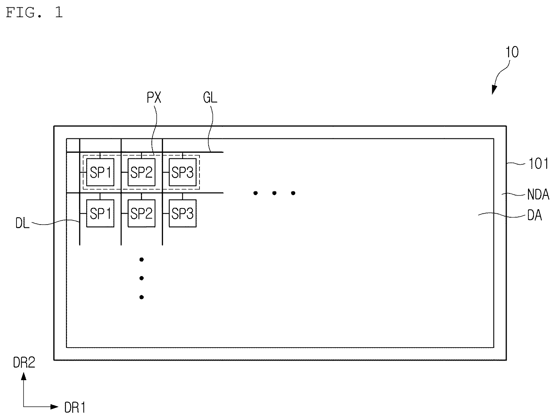

FIG. 1 is a plan view of a display apparatus according to one example embodiment.

Referring to FIG. 1, a display apparatus 10 according to one example embodiment of the present application may be applied to a TV, a signage, a mobile terminal such as a cell phone or smart phone, a computer display such as a laptop or desktop, a head-up display (HUD) for a vehicle, a display backlight unit, a virtual reality (VR), augmented reality (AR), or mixed reality (MR) display, etc. However, the configuration according to the embodiment described herein may be applied to any display-capable apparatus in the same manner even when a new product type is developed in the future.

The display apparatus 10 may use a micro light-emitting diode (LED) as a display element, but is not limited thereto.

The display apparatus 10 may include a flexible display manufactured on a thin, flexible substrate. A flexible display may maintain the characteristics of a conventional flat panel display and may be bent or rolled like paper.

The display apparatus 10 may include a display area DA in which a plurality of pixels PX are disposed, and a non-display area NDA in which an image is not displayed. The display apparatus 10 may include the substrate 110 that provides a space in which the plurality of pixels PX may be disposed.

The display area DA may display images, videos, pictures, etc., and include a plurality of pixels PX. The non-display area NDA does not display a screen and may also be referred to as an edge area or a bezel area. The non-display area NDA may be disposed outside the display area DA, but is not limited thereto. The non-display area NDA may be disposed around the display area DA, but is not limited thereto. The non-display area NDA may be disposed to surround the display area DA, but is not limited thereto.

The non-display area NDA may be defined as an area on the substrate 110 excluding the display area DA and may have a relatively narrow width (or size) compared to the display area DA, but is not limited thereto.

The pixel PX may be composed of a plurality of sub-pixels. For example, the pixel PX may be composed of a plurality of sub-pixels SP1, SP2, and SP3, and the sub-pixels SP1, SP2, and SP3 may emit red, blue, and green light, respectively. However, various embodiments of the present application are not limited thereto, and the pixel PX may also include sub-pixels that emit light of white, etc. In another exemplary embodiment, the sub-pixels SP1, SP2, and SP3 may emit cyan, magenta and yellow light, respectively. The sub-pixels SP1, SP2, and SP3 may be sequentially disposed in a first direction DR1. However, various embodiments of the present application are not limited thereto.

The pixel PX may be repeatedly disposed in the first direction DR1 and a second direction DR2. Specifically, each of the sub-pixels SP1, SP2, and SP3 may be alternately disposed in the first direction DR1. Each of the sub-pixels SP1, SP2, and SP3 may be repeatedly disposed in the second direction DR2.

The display apparatus 10 may further include a gate line GL and a data line DL that are electrically connected to the sub-pixels SP1, SP2, and SP3 of each pixel PX. The gate line GL and the data line DL may provide necessary signals to the sub-pixels SP1, SP2, and SP3 of each pixel PX. The display apparatus 10 may further include a gate line GL and a data line DL that are electrically connected to the sub-pixels SP1, SP2, and SP3 of each pixel PX. The gate line GL and the data line DL may provide necessary signals to the sub-pixels SP1, SP2, and SP3 of each pixel PX.

The gate line GL may extend in the first direction DR1 and may be repeatedly disposed in the second direction DR2. The data line DL may extend in the second direction DR2 different from the first direction DR1 and may be repeatedly disposed in the first direction DR1. The gate line GL and the data line DL may intersect each other. However, various embodiments of the present application are not limited thereto.

The substrate 110 is an array substrate on which transistors are formed and may be made of a plastic material or glass material, but is not limited thereto.

The substrate 110 may be made of the flexible polymer film. For example, the flexible polymer film may be made of any one of polyethylene terephthalate(PET), polycarbonate(PC), acrylonitrile-butadiene-styrene copolymer(ABS), polymethyl methacrylate(PMMA), polyethylene naphthalate(PEN), polyether sulfone(PES), cyclic olefin copolymer(COC), triacetylcellulose(TAC) film, polyvinyl alcohol(PVA) film, polyimide(PI) film, and polystyrene(PS), which is only an example and is not necessarily limited thereto.

In one example, the substrate 110 may include an opaque or colored polyimide material. In this case, the display apparatus 10 may further include a back plate coupled to a rear surface of the substrate 110 to maintain the substrate 110 in a flat surface state.

In one example, the back plate may include a plastic material, for example, a polyethylene terephthalate material.

In one example, the substrate 110 may be a glass substrate. For example, the glass substrate 110 may be a thin glass substrate having a thickness of 100 µm or less and may have flexible properties.

In addition, the substrate 110 may be formed by bonding two or more substrates or being divided into two or more layers.

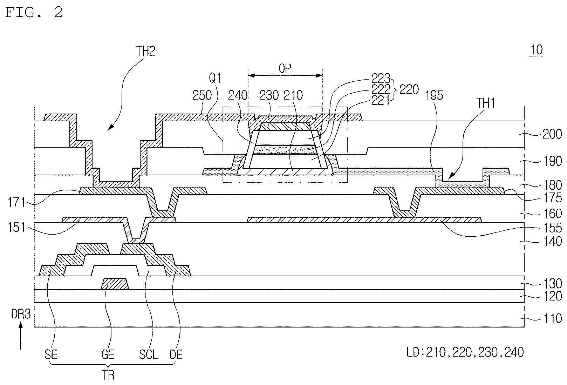

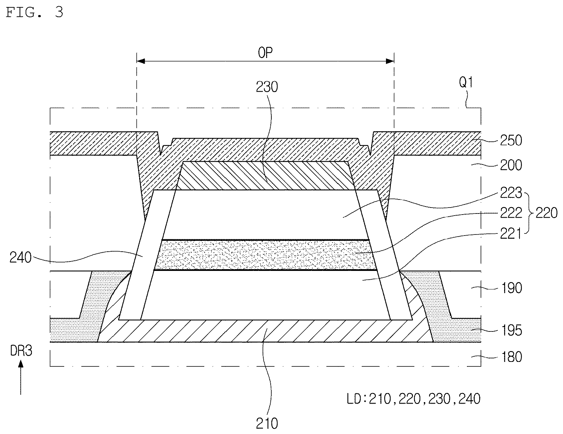

FIG. 2 is a view illustrating a cross-sectional structure of a sub-pixel according to one example embodiment. FIG. 3 is an enlarged view of area Q1 in FIG. 2.

Referring to FIGS. 2 and 3, the display apparatus 10 may further include a transistor TR and a light-emitting element LD that are disposed on the substrate 110. In addition, the display apparatus 10 may further include lines electrically connecting the transistor TR to the light-emitting element LD, and at least one insulating layer disposed between the components. For example, at least one insulating layer may be disposed on or over the substrate 110.

A buffer layer 120 may be disposed on the substrate 110. The buffer layer 120 can minimize or at least reduce the diffusion of moisture or impurities from the substrate 110. The buffer layer 120 may be made of silicon oxide (SiOₓ), silicon nitride (SiNₓ), etc. The buffer layer 120 may be formed of a single layer or multiple layers made of silicon oxide (SiOₓ), silicon nitride (SiNₓ), etc., but is not limited thereto.

The transistor TR may be disposed on the buffer layer 120. The transistor TR may be used as a driving element of the light-emitting element LD. The transistor TR may be a driving transistor, but is not limited thereto.

The transistor TR may be a thin-film transistor (TFT), an N-channel metal oxide semiconductor (NMOS), a P-channel metal oxide semiconductor (PMOS), a complementary metal oxide semiconductor (CMOS), a field effect transistor (FET), etc., but is not limited thereto.

The following description will be provided assuming that a plurality of transistors TR are thin-film transistors, but various embodiments of the present application are not limited thereto.

Each of the plurality of transistors TR includes a gate electrode GE, an active layer SCL, a source electrode SE, and a drain electrode DE.

The gate electrode GE is disposed on the buffer layer 120. For example, the gate electrode GE may be patterned and disposed on the buffer layer 120. The gate electrode GE may be made of a conductive material, such as copper (Cu), aluminum (Al), molybdenum (Mo), titanium (Ti), or an alloy thereof, but is not limited thereto.

The gate insulating layer 130 is disposed on the gate electrode GE. The gate insulating layer 130 may be disposed between the gate electrode GE and the active layer SCL. The gate insulating layer 130 may insulate the gate electrode GE from the active layer SCL and may be made of an insulation material. For example, the gate insulating layer 130 may be formed of a single layer or multiple layers made of silicon oxide (SiOₓ), silicon nitride (SiNₓ), etc., but is not limited thereto.

The active layer SCL is disposed on the gate insulating layer 130. For example, the active layer SCL may be made of an oxide semiconductor, amorphous silicon, polysilicon, etc., but is not limited thereto.

The source electrode SE and the drain electrode DE are disposed to be spaced apart from each other on the active layer SCL. The source electrode SE and the drain electrode DE may be electrically connected to the active layer SCL. The source electrode SE and the drain electrode DE may be made of a conductive material, such as copper (Cu), aluminum (Al), molybdenum (Mo), titanium (Ti), or an alloy thereof, but are not limited thereto.

In the aspects of the present disclosure, a source electrode and a drain electrode are distinguished from each other, for convenience of description. However, the source electrode and the drain electrode are used interchangeably. The source electrode may be the drain electrode, and the drain electrode may be the source electrode. Also, the source electrode in any one aspect of the present disclosure may be the drain electrode in another aspect of the present disclosure, and the drain electrode in any one aspect of the present disclosure may be the source electrode in another aspect of the present disclosure.

In FIG. 2, the gate electrode GE is illustrated as being disposed below the active layer SCL, but is not limited thereto. For example, in FIG. 2, the active layer SCL is illustrated as being disposed between the source electrode SE and the drain electrode DE, and the gate electrode GE, but is not limited thereto. For example, the active layer SCL and the gate insulating layer 130 are illustrated as being disposed between the source electrode SE and the drain electrode DE, and the gate electrode GE, but is not limited thereto.

For example, the gate electrode GE may also be disposed above the active layer SCL. In this case, the gate electrode GE may be disposed between the source electrode SE and the drain electrode DE, and the active layer SCL.

A first planarization layer 140 may be disposed on the transistor TR. The first planarization layer 140 may planarize an upper portion of the substrate 110 including the plurality of transistors TR.

The first planarization layer 140 may be formed of a single layer or multiple layers and may be made of an organic material. For example, the first planarization layer 140 may be made of an acrylic-based organic material, but is not limited thereto. The first planarization layer 140 includes a contact hole for electrically connecting the transistor TR to the first connection electrode 151.

The first planarization layer 140 may be formed of one or more materials of acrylic resin, epoxy resin, phenolic resin, polyamides resin, unsaturated polyesters resin, polyphenylene resin, polyphenylene sulfides resin, and benzocyclobutene, but embodiments are not limited thereto.

Although not illustrated, a protective layer may be further disposed between the first planarization layer 140 and the transistor TR to protect underlying components.

A first connection electrode 151 and a second connection electrode 155 may be disposed on the first planarization layer 140.

The first connection electrode 151 and the second connection electrode 155 may be disposed on the same layer and made of the same material, but is not limited thereto. For example, the first connection electrode 151 and the second connection electrode 155 may be made of different materials. The first connection electrode 151 and the second connection electrode 155 may be disposed on the first planarization layer 140 and made of a metallic material. For example, the first connection electrode 151 and the second connection electrode 155 may include a light-reflecting conductive material, and the light-reflecting conductive material may include at least one selected from aluminum (Al), silver (Ag), gold (Au), platinum (Pt), copper (Cu), etc.

The first connection electrode 151 may be overlapped with the transistor TR. The first connection electrode 151 may be electrically connected to and in contact with the drain electrode DE of the transistor TR through a contact hole passing through the first planarization layer 140 in a thickness direction (third direction DR3).

Although not illustrated, the second connection electrode 155 may be electrically connected to a common power terminal (high-potential voltage terminal) and may receive and transmit common power.

A second planarization layer 160 may be disposed on the first connection electrode 151 and the second connection electrode 155. The second planarization layer 160 may be disposed to cover the first connection electrode 151 and the second connection electrode 155. The second planarization layer 160 may be made of an organic material. For example, the second planarization layer 160 may be made of an acrylic-based organic material, but is not limited thereto. The second planarization layer 160 may be made of the same material as the first planarization layer 140, but is not limited thereto.

A third connection electrode 171 and a fourth connection electrode 175 may be disposed on the second planarization layer 160. The third connection electrode 171 and a fourth connection electrode 175 may be disposed to cover the second planarization layer 160. The third connection electrode 171 and the fourth connection electrode 175 may include the same material as the first connection electrode 151 and the second connection electrode 155, but are not limited thereto.

The third connection electrode 171 may be overlapped with the first connection electrode 151. The third connection electrode 171 may be electrically connected to and in contact with the first connection electrode 151 through a contact hole passing through the second planarization layer 160 in the thickness direction (third direction DR3).

The fourth connection electrode 175 may be overlapped with the second connection electrode 155. The fourth connection electrode 175 may be electrically connected to and in contact with the second connection electrode 155 through a contact hole passing through the second planarization layer 160 in the thickness direction (third direction DR3).

An adhesive layer 180 may be disposed on the third connection electrode 171 and the fourth connection electrode 175. The adhesive layer 180 may be disposed over the entire area of the second planarization layer 160 while covering the third connection electrode 171 and the fourth connection electrode 175.

The adhesive layer 180 may fix the light-emitting element LD disposed on the adhesive layer 180. The adhesive layer 180 may be formed of an organic insulating layer. The adhesive layer 180 may be made of a photocurable adhesive material which may be cured by light. For example, the adhesive layer 180 may be made of an acrylic-based material containing a photosensitive agent, but is not limited thereto.

The light-emitting element LD may be disposed on the adhesive layer 180. The light-emitting element LD may be an LED or micro LED, but is not limited thereto. The light-emitting element LD may have a vertical structure, but is not limited thereto.

The light-emitting element LD may include a first electrode 210, the light-emitting layer 220, a second electrode 230, and a passivation film 240. The light-emitting layer 220 may include a first semiconductor layer 221, an active layer 222, and a second semiconductor layer 223. When the light-emitting element LD has a vertical structure, the first electrode 210, the first semiconductor layer 221, the active layer 222, the second semiconductor layer 223, and the second electrode 230 may overlap in the thickness direction (third direction DR3). For example, the first electrode 210 may be disposed on the adhesive layer 180. The first semiconductor layer 221, the active layer 222 and the second semiconductor layer 223 may be disposed on the first electrode 210.

The first electrode 210, the light-emitting layer 220, and the second electrode 230 may be sequentially disposed in the thickness direction (third direction DR3). The first electrode 210, the light-emitting layer 220, and the second electrode 230 may overlap in the thickness direction (third direction DR3). The light-emitting layer 220 may be disposed between the first electrode 210 and the second electrode 230. The active layer 222 of the light-emitting layer 220 may be disposed between the first semiconductor layer 221 and the second semiconductor layer 223 of the light-emitting layer 220.

The first electrode 210 may be disposed between the adhesive layer 180 and the light-emitting layer 220. The first electrode 210 may be one of an anode electrode and a cathode electrode. For example, the first electrode 210 may be a cathode electrode, but is not limited thereto.

When the first electrode 210 is the cathode electrode, the first electrode 210 may be electrically connected to the common voltage terminal (or high-potential voltage terminal). When the first electrode 210 is the cathode electrode, the common voltage terminal (or the high-potential voltage terminal) and the first semiconductor layer 221 may be electrically connected through the first electrode 210.

The first electrode 210 may include a conductive material. The conductive material may be made of at least one selected from, for example, transparent conductive materials, such as ITO, IZO, etc., or opaque conductive materials, such as nickel (Ni), gold (Au), platinum (Pt), titanium (Ti), aluminum (Al), chromium (Cr), copper (Cu), silver (Ag), or an alloy thereof, but is not limited thereto.

The light-emitting layer 220 may be disposed on the first electrode 210. The first semiconductor layer 221, the active layer 222, and the second semiconductor layer 223 of the light-emitting layer 220 may be sequentially disposed on the first electrode 210 in the thickness direction. The active layer 222 may be disposed between the first semiconductor layer 221 and the second semiconductor layer 223.

For example, the light-emitting layer 220 may include one or more of a hole injection layer (HIL), a hole transmitting layer (HTL), an electron transmitting layer (ETL) and an electron injection layer (EIL), but the present disclosure is not limited thereto.

The first semiconductor layer 221 may be disposed on the first electrode 210. The first semiconductor layer 221 may be disposed between the first electrode 210 and the active layer 222. The first semiconductor layer 221 may include a first-type dopant. For example, the first semiconductor layer 221 may include an n-type dopant, but is not limited thereto.

When the first semiconductor layer 221 includes the n-type dopant, the first semiconductor layer 221 may supply electrons to the active layer 222 and have a material, such as gallium nitride (GaN), indium aluminum phosphide (InAlP), gallium arsenide (GaAs), etc., coated with impurities, such as silicon (Si), germanium (Ge), selenium (Se), tellurium (Te), etc.

The active layer 222 may be disposed on the first semiconductor layer 221. The active layer 222 may receive electrons and holes from the first semiconductor layer 221 and the second semiconductor layer 223 and emit light. The active layer 222 may be formed in a single-layer or multi-quantum well (MQW) structure and may be made of, for example, indium gallium nitride (InGaN), gallium nitride (GaN), etc., but is not limited thereto.

The second semiconductor layer 223 may be disposed on the active layer 222. The second semiconductor layer 223 may be disposed between the active layer 222 and the second electrode 230. The second semiconductor layer 223 may include a second-type dopant different from the first-type dopant. For example, the second semiconductor layer 223 may include a p-type dopant, but is not limited thereto.

When the second semiconductor layer 223 includes the p-type dopant, the second semiconductor layer 223 may supply holes to the active layer 222 and have a material, such as gallium nitride (GaN), indium aluminum phosphide (InAlP), gallium arsenide (GaAs), etc., coated with impurities, such as magnesium (Mg), zinc (Zn), beryllium (Be), etc.

The present application describes the first semiconductor layer 221 including the n-type dopant and the second semiconductor layer 223 including the p-type dopant, but various embodiments of the present application are not limited thereto, and the first semiconductor layer 221 may include the p-type dopant and the second semiconductor layer 223 may include the n-type dopant. For example, the active layer 222 may receive holes and electrons from the first semiconductor layer 221 and the second semiconductor layer 223 and emit light.

The light-emitting layer 220 may have a mesa structure. A side surface of the light-emitting layer 220 may be formed as an inclined surface inclined with respect to the thickness direction (third direction DR3). A planar size of the light-emitting layer 220 may decrease from the first semiconductor layer 221 toward the second semiconductor layer 223. A width of the light-emitting layer 220 may decrease from the first semiconductor layer 221 toward the second semiconductor layer 223, but is not limited thereto.

The second electrode 230 may be disposed on the light-emitting layer 220. The second electrode 230 may be disposed on the second semiconductor layer 223 of the light-emitting layer 220. For example, the second electrode 230 may be disposed on the entire surface of the second semiconductor layer 223. The second electrode 230 may be one of an anode electrode or a cathode electrode. For example, when the first electrode 210 is the cathode electrode, the second electrode 230 may be the anode electrode, but is not limited thereto. For example, when the first electrode 210 is the anode electrode, the second electrode 230 may be the cathode electrode.

The present application describes the first electrode 210 being the cathode electrode and the second electrode 230 being the anode electrode, but various embodiments of the present application are not limited thereto. For example, the first electrode 210 may be the anode electrode and the second electrode 230 may be the cathode electrode.

When the second electrode 230 is the anode electrode, the second electrode 230 may be electrically connected to the transistor TR. When the second electrode 230 is the anode electrode, the transistor TR and the second semiconductor layer 223 may be electrically connected through the second electrode 230.

The second electrode 230 may include a conductive material. The conductive material may be made of at least one selected from, for example, transparent conductive materials, such as ITO, IZO, etc., or opaque conductive materials, such as nickel (Ni), gold (Au), platinum (Pt), titanium (Ti), aluminum (Al), chromium (Cr), copper (Cu), silver (Ag), or an alloy thereof, but is not limited thereto.

The passivation film 240 may be disposed on the side surface of the light-emitting layer 220. The passivation film 240 may be disposed along the perimeter of the light-emitting layer 220 and disposed to surround the light-emitting layer 220.

The passivation film 240 may come into direct contact with the side surface of the light-emitting layer 220. The passivation film 240 may be disposed on side surfaces of the first semiconductor layer 221, the active layer 222, and the second semiconductor layer 223. The passivation film 240 may come into direct contact with the side surfaces of the first semiconductor layer 221, the active layer 222, and the second semiconductor layer 223.

The passivation film 240 may be made of an inorganic insulation material, such as silicon oxide, silicon nitride, silicon oxynitride, aluminum oxide, etc., but is not limited thereto.

The passivation film 240 can protect the light-emitting layer 220, prevent or at least reduce leakage current flowing to the side of the light-emitting layer 220, and suppress, prevent or at least reduce short circuits between the light-emitting layer 220 and connection electrodes 195 and 250.

A common connection electrode 195 may be disposed on the adhesive layer 180. The common connection electrode 195 may be in contact with the light-emitting element LD. The common connection electrode 195 may be made of the same material as a pixel connection electrode 250, but is not limited thereto.

The adhesive layer 180 may define a first through-hole TH1 that passes through in the thickness direction (third direction DR3) to expose the fourth connection electrode 175. The common connection electrode 195 may be disposed on the fourth connection electrode 175 through the first through-hole TH1.

The common connection electrode 195 may be electrically connected to and in contact with the first electrode 210. For example, the common connection electrode 195 may be in contact with side surfaces of the first electrode 210. Through the first through-hole TH1, the common connection electrode 195 may be electrically connected to and in contact with the fourth connection electrode 175 exposed by the first through-hole TH1. For example, the first electrode 210 and the fourth connection electrode 175 may be electrically connected by the common connection electrode 195.

A portion of the first electrode 210 may be disposed between outer surfaces of the common connection electrode 195 and the passivation film 240.

The common connection electrode 195 may come into direct contact with side surfaces of the first electrode 210. The common connection electrode 195 may be disposed to surround the first electrode 210 along the perimeter of the first electrode 210. Accordingly, since a contact area between the common connection electrode 195 and the first electrode 210 can be increased, the light-emitting element LD and the common connection electrode 195 can be more smoothly electrically connected. Furthermore, the electrical characteristics of the display apparatus 10 can be improved, enabling low-voltage driving or improving light efficiency or luminance by applying a higher voltage.

The first electrode 210 may protrude outward from the side surface of the light-emitting layer 220. The first electrode 210 may protrude further outward than side surfaces of the passivation film 240. The planar size (area) of the first electrode 210 may be larger than that of the light-emitting layer 220.

The first electrode 210 may overlap the entire area of the light-emitting layer 220 in the thickness direction (third direction DR3). The first electrode 210 may overlap the entire area of the passivation film 240 in the thickness direction (third direction DR3).

The first electrode 210 may extend along an outer surface of the passivation film 240 in the thickness direction (third direction DR3). The first electrode 210 may extend along the outer surface of the passivation film 240 in the thickness direction (third direction DR3) near the edge of the passivation film 240. A portion of the passivation film 240 may be disposed between the light-emitting layer 220 and the first electrode 210. A portion of the first electrode 210 may be disposed between the passivation film 240 and the common connection electrode 195.

The first electrode 210 may extend in the thickness direction (third direction DR3) in an area that protrudes further outward than the side surface of the passivation film 240 and may be disposed on a portion of the outer surface of the passivation film 240. The first electrode 210 may come into direct contact with the portion of the outer surface and lower surface of the passivation film 240.

An inner surface of the passivation film 240 may be disposed on the light-emitting layer 220 to come into direct contact with the light-emitting layer 220, and the portion of the outer surface of the passivation film 240 may be covered by the first electrode 210. For example, the lower portion of the outer surface of the passivation film 240 may be covered by the first electrode 210. The first electrode 210 may come into direct contact with the outer surface of the passivation film 240. At least a portion of the passivation film 240 may be disposed between the first electrode 210 and the light-emitting layer 220.

As the first electrode 210 extends along the outer surface of the passivation film 240 in the thickness direction (third direction DR3), an area in which the first electrode 210 may come into contact with the common connection electrode 195 can further increase. Accordingly, the electrical characteristics of the display apparatus 10 can be further improved, thereby enabling smoother low-voltage driving, or a higher voltage may be applied, thereby improving light efficiency and luminance more smoothly.

A first insulating layer 190 and a second insulating layer 200 may be sequentially disposed on the common connection electrode 195. The first insulating layer 190 may be disposed between the adhesive layer 180 and the second insulating layer 200. For example, the first insulating layer 190 may be disposed between the adhesive layer 180, the common connection electrode 195 and the second insulating layer 200.

The first insulating layer 190 and the second insulating layer 200 may be disposed on the adhesive layer 180 while covering the common connection electrode 195. The second insulating layer 200 may cover at least a portion of the light-emitting element LD. The first insulating layer 190 and the second insulating layer 200 may be formed to have a thickness sufficient to completely cover the light-emitting element LD.

The first insulating layer 190 and the second insulating layer 200 may provide a flat surface on the transistor TR and the light-emitting element LD and fix the position of the light-emitting element LD.

The pixel connection electrode 250 may be disposed on the second insulating layer 200. The pixel connection electrode 250 may be in contact with the upper surface and side surfaces of the second electrode 230. The adhesive layer 180, the first insulating layer 190, and the second insulating layer 200 may define a second through-hole TH2 that passes through in the thickness direction (third direction DR3) to expose the third connection electrode 171. The second insulating layer 200 may define an opening OP that passes through in the thickness direction (third direction DR3) to expose the light-emitting element LD. The opening OP may expose the second electrode 230.

Through the opening OP, the pixel connection electrode 250 may be electrically connected to and in contact with the second electrode 230 exposed by the opening OP.

Through the second through-hole TH2, the pixel connection electrode 250 may be electrically connected to and in contact with the third connection electrode 171 exposed by the second through-hole TH2. For example, the second electrode 230 and the third connection electrode 171 may be electrically connected by the pixel connection electrode 250.

The pixel connection electrode 250 may be made of a transparent conductive material when the display apparatus 10 is a top-emission type, or may be made of a light-reflecting conductive material when the display apparatus 10 is a bottom-emission type. The transparent conductive material may be ITO, IZO, etc., but is not limited thereto. The light-reflecting conductive material may be Al, Ag, Au, Pt, Cu, etc., but is not limited thereto. The pixel connection electrode 250 made of the light-reflecting conductive material may be formed of a single layer containing the light-reflecting conductive material or multiple layers in which single layers are stacked.

The opening OP may be larger than the second electrode 230. A sidewall of the opening OP may be formed of the second insulating layer 200, and the sidewall of the opening OP may be disposed to be spaced apart from the second electrode 230 and may surround the second electrode 230.

The opening OP may overlap the entire area of the second electrode 230 in the thickness direction (third direction DR3). The entire area of the second electrode 230 may be disposed inside the opening OP.

The opening OP may expose all of an upper surface and side surfaces of the second electrode 230 and expose a portion of an upper side of the passivation film 240, but is not limited thereto.

At least a portion of the pixel connection electrode 250 may be disposed inside the opening OP. When the opening OP exposes all of the upper surface and side surfaces of the second electrode 230, the pixel connection electrode 250 may come into contact with all of the upper surface and side surfaces of the second electrode 230 exposed by the opening OP. The pixel connection electrode 250 may come into direct contact with all of the upper surface and side surfaces of the second electrode 230 exposed by the opening OP. Here, the upper surface of the second electrode 230 is an opposite surface of a lower surface of the second electrode 230 facing the light-emitting layer 220.

When the opening OP exposes a portion of the passivation film 240, the pixel connection electrode 250 may come into direct contact with the passivation film 240 exposed by the opening OP. The pixel connection electrode 250 may come into direct contact with an upper surface and outer surface of the passivation film 240 exposed by the opening OP.

As the opening OP exposes all of the upper and side surfaces of the second electrode 230, the area in which the second electrode 230 may come into contact with the pixel connection electrode 250 can increase. Accordingly, the electrical characteristics of the display apparatus 10 can be further improved, thereby enabling smoother low-voltage driving, or a higher voltage may be applied, thereby improving light efficiency and luminance more smoothly.

Hereinafter, a method of manufacturing the display apparatus 1 according to one example embodiment will be described. While describing the method of manufacturing the display apparatus 1 according to one example embodiment, the descriptions of parts already described in FIGS. 1 to 3 will be briefly given or omitted.

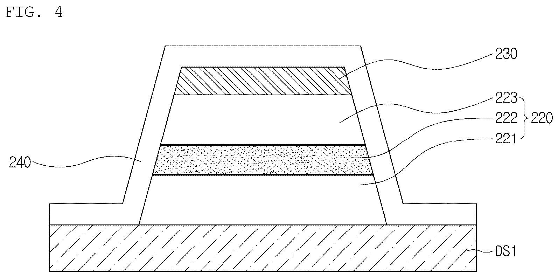

FIGS. 4 to 12 are views illustrating each operation of a process of manufacturing the display apparatus according to one example embodiment.

Referring to FIG. 4, the first semiconductor layer 221, the active layer 222, and the second semiconductor layer 223 may be epitaxially grown on the entire surface of a first dummy substrate DS1. During this process, the first semiconductor layer 221 and the second semiconductor layer 223 may each be doped with one of a first-type dopant and a second-type dopant. The second electrode 230 may be formed over the entire surface of the second semiconductor layer 223. A width of the light-emitting layer 220 may decrease from the first semiconductor layer 221 toward the second semiconductor layer 223, but is not limited thereto.

The first semiconductor layer 221, the active layer 222, the second semiconductor layer 223, and the second electrode 230 that are formed over the entire surface of the first dummy substrate DS1 may be patterned and formed in a plurality of independent island shapes. FIG. 4 illustrates only a single patterned island shape, but various embodiments of the present application are not limited thereto, and a plurality of island-shaped portions may be formed.

After the first semiconductor layer 221, the active layer 222, the second semiconductor layer 223, and the second electrode 230 are patterned, the passivation film 240 may be formed. The passivation film 240 may be formed over the entire surface of the first dummy substrate DS1 while covering the first semiconductor layer 221, the active layer 222, the second semiconductor layer 223, and the second electrode 230 that are patterned. For example, the passivation film 240 may be formed to cover the side surfaces of the light-emitting layer 220 and upper and side surfaces of the second electrode 230.

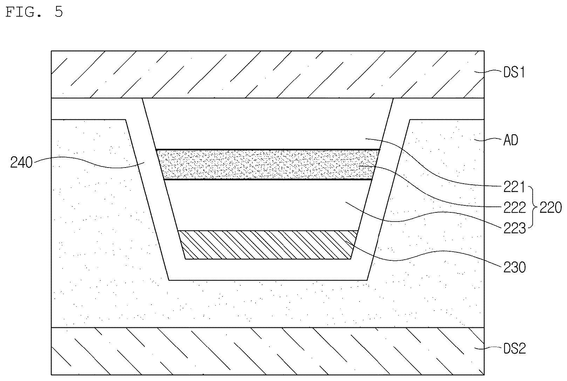

Next, referring further to FIG. 5, the passivation film 240, and the first semiconductor layer 221, the active layer 222, the second semiconductor layer 223, and the second electrode 230 that are patterned are attached to a second dummy substrate DS2 through an adhesive AD. The adhesive AD may be disposed over the entire area between the first dummy substrate DS1 and the second dummy substrate DS2.

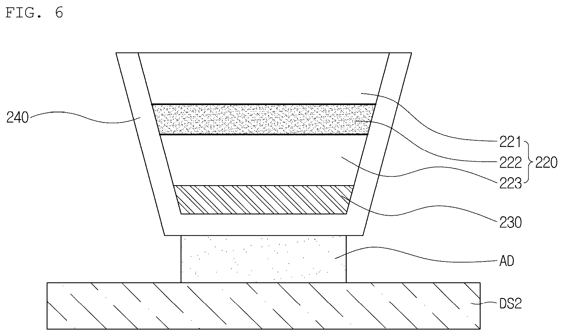

Next, referring to FIG. 6, the first dummy substrate DS1 and a portion of the passivation film 240 in direct contact with the first dummy substrate DS1 are removed, and a portion of the adhesive AD is removed. The remaining adhesive AD may expose the side surfaces of the passivation film 240 and may be disposed in an island shape between the passivation film 240 and the second dummy substrate DS2.

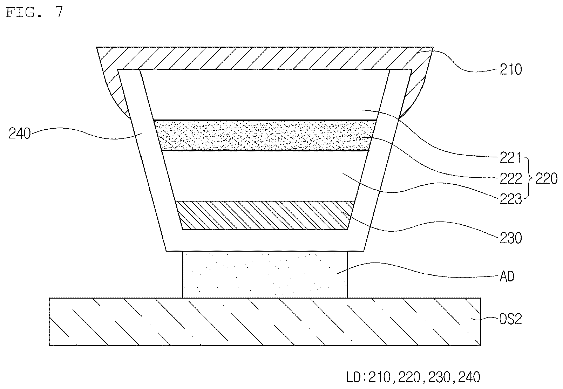

Next, referring to FIG. 7, the first electrode 210 is formed on the exposed first semiconductor layer 221. By forming the first electrode 210 on the exposed first semiconductor layer 221, the light-emitting element LD is formed. The first electrode 210 may be formed not only on the exposed first semiconductor layer 221, but also to extend to the side surfaces of the passivation film 240. For example, the side surfaces of the first electrode 210 may protrude further outward than the outer surface of the passivation film 240. A portion of the first electrode 210 may be disposed on the outer surface of the passivation film 240.

By first patterning the first semiconductor layer 221, the active layer 222, the second semiconductor layer 223, and the second electrode 230 and forming the first electrode 210 on the first semiconductor layer 221, the first electrode 210 may be formed to protrude further outward than the side surfaces of the first semiconductor layer 221, and furthermore, may be formed to extend to the side surfaces of the passivation film 240. A portion of the first electrode 210 may be formed to extend to the outer surface of the passivation film 240, but is not limited thereto.

Accordingly, since the contact area between the common connection electrode 195 and the first electrode 210 can be increased, the light-emitting element LD and the common connection electrode 195 can be more smoothly electrically connected.

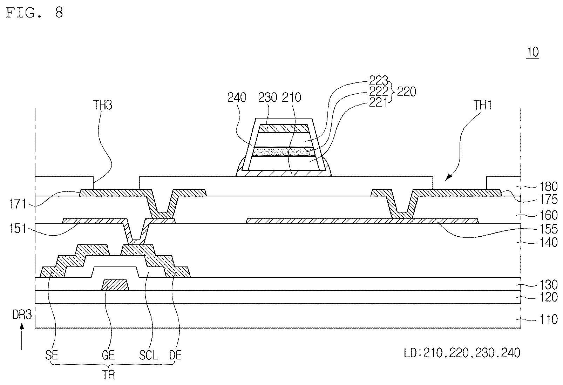

Next, referring to FIG. 8, the light-emitting element LD is transferred onto the substrate 110 on which the buffer layer 120, the transistor TR, the gate insulating layer 130, the first planarization layer 140, the second planarization layer 160, the adhesive layer 180, and the connection electrodes 151, 155, 171, and 175 are disposed. The light-emitting element LD may be transferred onto the adhesive layer 180.

The adhesive layer 180 may define the first through-hole TH1 exposing the fourth connection electrode 175 and a third through-hole TH3 exposing the third connection electrode 171. The third through-hole TH3 may be a portion of the second through-hole TH2 in FIG. 2. The light-emitting element LD may be transferred onto the portion of the adhesive layer 180 except for the first through-hole TH1 and the third through-hole TH3.

After the light-emitting element LD is transferred, a lighting test may be performed to determine whether the light-emitting element LD is operating normally.

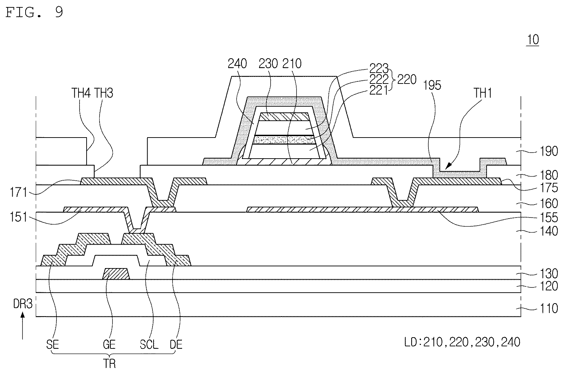

Next, referring to FIG. 9, the common connection electrode 195 and the first insulating layer 190 are formed.

The common connection electrode 195 may extend to the first through-hole TH1 while covering the entire area of the light-emitting element LD. Accordingly, the common connection electrode 195 may be electrically connected to and in contact with the first electrode 210 and the fourth connection electrode 175.

The first insulating layer 190 may be formed on the adhesive layer 180 while covering the common connection electrode 195. The first insulating layer 190 may be patterned in an area in which the third through-hole TH3 is disposed to expose the third through-hole TH3, and thus the fourth through-hole TH4 may be defined. A width of the fourth through-hole TH4 may be larger than that of the third through-hole TH3, but is not limited thereto. The fourth through-hole TH4 passing through the first insulating layer 190 may be overlapped with the third through-hole TH3 passing through the adhesive layer.

As illustrated in FIGS. 8 and 9, by transferring the light-emitting element LD and forming the conductive layer (such as the common connection electrode 195) separately, the stability of each process can be improved, and the stability of the process in which the light-emitting element LD comes into contact with the conductive layer (such as the common connection electrode 195) can also be improved. Accordingly, process efficiency can be improved, process costs can be reduced, and furthermore, production energy can be reduced.

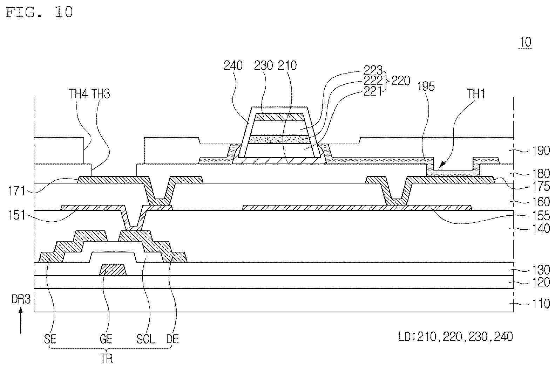

Next, referring to FIG. 10, a portion of the first insulating layer 190 and a portion of the common connection electrode 195 may be etched. The etching process may be performed using dry etching, but is not limited thereto.

Through the etching process, the portion of the first insulating layer 190 and the portion of the common connection electrode 195 that are disposed on the light-emitting element LD may be removed. A portion of the common connection electrode 195, which does not come into contact with the first electrode 210, may be removed, and a portion of the first insulating layer 190 disposed on the corresponding area of the common connection electrode 195 may also be removed. An upper surface of the common connection electrode 195 exposed by etching may have the same height as the upper surface of the surrounding first insulating layer 190, but is not limited thereto.

As the portion of the first insulating layer 190 and the portion of the common connection electrode 195 are removed, a portion of the passivation film 240 disposed on the light-emitting element LD may be exposed. For example, a lower portion of the passivation film 240 may be covered by the first insulating layer 190 and the common connection electrode 195, and the upper portion of the passivation film 240 may be exposed.

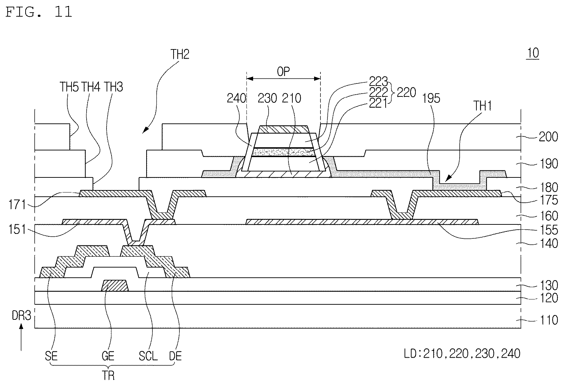

Next, referring to FIG. 11, the second insulating layer 200 is formed on the first insulating layer 190.

The second insulating layer 200 may be patterned to define a fifth through-hole TH5 that exposes the third through-hole TH3 and the fourth through-hole TH4. Accordingly, the second through-hole TH2 may be formed. For example, a width of the fifth through-hole TH5 may be larger than the widths of the third through-hole TH3 and the fourth through-hole TH4, but is not limited thereto.

The second insulating layer 200 may be patterned to define the opening OP that exposes the second electrode 230 and the passivation film 240. During the patterning process of the second insulating layer 200, the passivation film 240 covering the second electrode 230 may also be removed. However, various embodiments of the present application are not limited thereto, and the passivation film 240 covering the second electrode 230 may be removed through a separate etching process.

The opening OP may be formed to be larger than the second electrode 230, and the sidewalls of the opening OP may be formed to surround the second electrode 230. The opening OP may overlap the entire area of the second electrode 230 in the thickness direction (third direction DR3). The entire area of the second electrode 230 may be disposed inside the opening OP.

Accordingly, the side surfaces and upper surface of the second electrode 230 may be exposed, and the second electrode 230 may come into contact with the pixel connection electrode 250 across the side surfaces and upper surface thereof. For example, the area in which the second electrode 230 may come into contact with the pixel connection electrode 250 can be increased. For example, the pixel connection electrode 250 may cover the side surfaces and upper surface of the second electrode 230.

In addition, a tolerance required for the alignment of the second electrode 230 and the pixel connection electrode 250 can be increased, thereby performing the process more efficiently and reducing process time and cost.

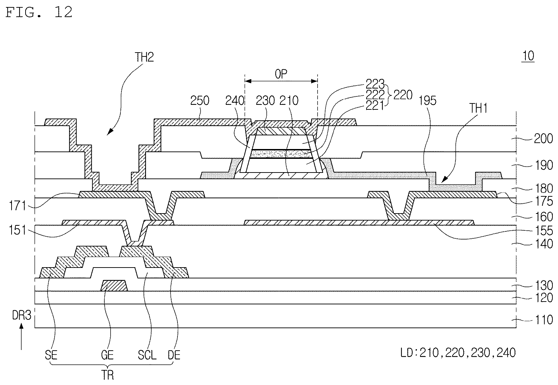

Next, referring to FIG. 12, the pixel connection electrode 250 is formed on the second insulating layer 200.

The pixel connection electrode 250 may be patterned and may have one end disposed inside the second through-hole TH2 to come into contact with the third connection electrode 171 and the other end disposed inside the opening OP to come into contact with the second electrode 230. The second electrode 230 and the third connection electrode 171 may be electrically connected by the pixel connection electrode 250.

Although not illustrated, after the pixel connection electrode 250 is patterned, a black matrix may be further disposed on the second through-hole TH2, the second insulating layer 200, and the pixel connection electrode 250. The black matrix may be disposed over the entire area of the display area DA (see FIG. 1) excluding the light-emitting area of each pixel PX (see FIG. 1).

An upper protective layer, a cover glass, etc., may be further disposed on the black matrix to planarize an upper portion and protect underlying components.

A plurality of light-emitting elements LD may be disposed for each of the plurality of sub-pixels, but is not limited thereto. A plurality of light-emitting elements LD may be disposed for each of the sub-pixels SP1, SP2, and SP3 (see FIG. 1). For example, two light-emitting elements LD may be transferred onto each of the sub-pixels SP1, SP2, and SP3 (see FIG. 1), but is not limited thereto. More or less light-emitting elements LD may be transferred onto each of the plurality of sub-pixels.

Accordingly, when one of the two light-emitting elements LD disposed in each of the sub-pixels SP1, SP2, and SP3 (see FIG. 1) is defective, light may be emitted from the corresponding sub-pixel SP1, SP2, or SP3 (see FIG. 1)through the other light-emitting element LD. Alternatively, the two light-emitting elements LD disposed in each of the sub-pixels SP1, SP2, and SP3 (see FIG. 1) may operate as redundant LEDs that emit light.

Hereinafter, other example embodiments of the present application will be described. For contents that are substantially the same as those described with reference to FIGS. 1 to 12 among components included in other example embodiments, the same reference numerals are given, and the overlapping contents may be omitted or briefly described.

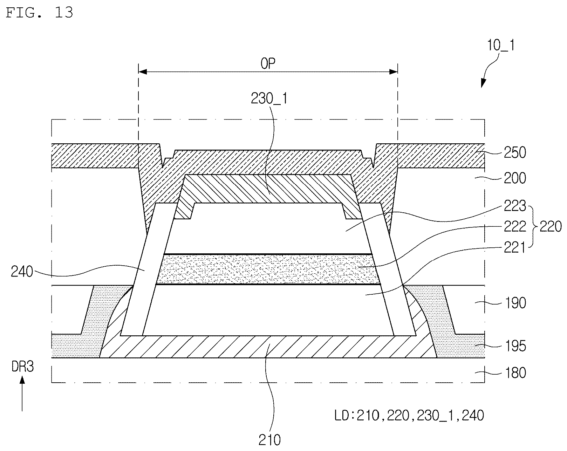

FIG. 13 is a cross-sectional view of a display apparatus according to another example embodiment. FIG. 13 is an enlarged view of an area surrounding the light-emitting element LD.

Referring to FIG. 13, a display apparatus 10_1 according to another example embodiment may include the light-emitting element LD. A second electrode 230_1 of the light-emitting element LD may extend to protrude toward the second semiconductor layer 223 near side surfaces thereof. The second electrode 230_1 may be thicker near the side surfaces thereof. Accordingly, the second semiconductor layer 223 may be thinner near the side surfaces thereof.

A portion of the second electrode 230_1 may be disposed between the second semiconductor layer 223 and the passivation film 240. The second electrode 230_1 protruding toward the second semiconductor layer 223 may be disposed between the second semiconductor layer 223 and the passivation film 240. For example, the second electrode 230_1 protruding toward the second semiconductor layer 223 may be disposed between the side surface of the second semiconductor layer 223 and the passivation film 240.

As illustrated in FIG. 4, the first semiconductor layer 221, the active layer 222, and the second semiconductor layer 223 may be epitaxially grown, and then the second semiconductor layer 223 may be patterned. By patterning the second semiconductor layer 223, the second semiconductor layer 223 may be formed to have different thicknesses for each area, and some areas may be formed to further protrude than others. For example, the second semiconductor layer 223 may be thinner near the side surfaces thereof.

By forming the second electrode 230_1 on the patterned second semiconductor layer 223, the second electrode 230_1 may be formed to protrude and extend toward the second semiconductor layer 223 near the side surfaces thereof.

The side surfaces of the second electrode 230_1 may be closer to the light-emitting layer 220. Accordingly, non-luminous coupling that may occur at the side surfaces of the second electrode 230_1 can be reduced, and current leakage to the side surfaces can be suppressed, prevented or at least reduced. Furthermore, the luminous efficiency of the light-emitting element LD can be improved.

Even in this case, the contact area between the common connection electrode 195 and the first electrode 210 and the contact area between the pixel connection electrode 250 and the second electrode 230_1 can be increased, thereby improving the electrical characteristics of the display apparatus 10_1, enabling low-voltage driving, or a higher voltage may be applied, thereby improving light efficiency or luminance.

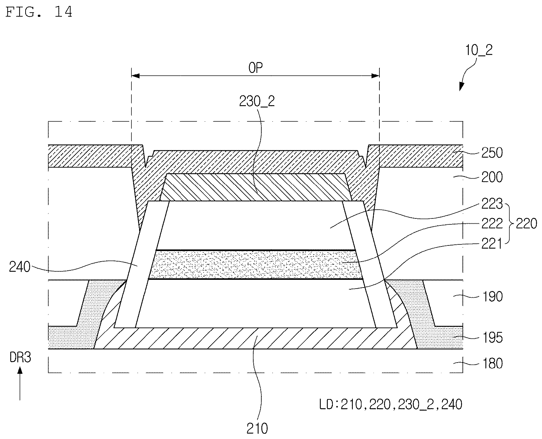

FIG. 14 is a cross-sectional view of a display apparatus according to still another example embodiment. FIG. 14 is an enlarged view of an area surrounding the light-emitting element LD.

Referring to FIG. 14, a display apparatus 10_2 according to still another example embodiment may include the light-emitting element LD. A second electrode 230_2 may be larger than the second semiconductor layer 223.

For example, the second electrode 230_2 may be disposed on the second semiconductor layer 223 and a portion of the passivation film 240. The second electrode 230_2 may cover an upper surface of the second semiconductor layer 223 and a portion of an upper side of the passivation film 240.

The second electrode 230_2 may protrude further outward than the side surfaces of the second semiconductor layer 223. The second electrode 230_2 may be disposed on the upper surface of the passivation film 240, and the second electrode 230_2 may come into direct contact with the upper surface of the passivation film 240.

The outer surface of the passivation film 240 may be disposed further outward than side surfaces of the second electrode 230_2. The side surfaces of the second electrode 230_2 may be disposed between the outer and inner surfaces of the passivation film 240.

The second electrode 230_2 may overlap the passivation film 240 in the thickness direction (third direction DR3). For example, the second electrode 230_2 may overlap the second semiconductor layer 223 and a portion of the passivation film 240 in the thickness direction (third direction DR3).

As illustrated in FIG. 4, the first semiconductor layer 221, the active layer 222, and the second semiconductor layer 223 may be epitaxially grown and then immediately patterned. The passivation film 240 may be formed on the first semiconductor layer 221, the active layer 222, and the second semiconductor layer 223 that are patterned, and a portion of the formed passivation film 240 may be removed to expose the second semiconductor layer 223.

Thereafter, the second electrode 230_2 may be formed on the second semiconductor layer 223 exposed by the passivation film 240. Accordingly, the second electrode 230_2 may be formed across the second semiconductor layer 223 and the passivation film 240.

Even in this case, the contact area between the common connection electrode 195 and the first electrode 210 and the contact area between the pixel connection electrode 250 and the second electrode 230_2 can be increased, thereby improving the electrical characteristics of the display apparatus 10_2, enabling low-voltage driving, or a higher voltage may be applied, thereby improving light efficiency or luminance.

A display apparatus according to various example embodiments of the present application may be described as follows.

According to various example embodiments of the present application, there is provided a display apparatus including a substrate, a light-emitting element disposed on the substrate, and a common connection electrode disposed on the substrate and in contact with the light-emitting element, in which the light-emitting element includes a first electrode disposed on the substrate, a light-emitting layer disposed on the first electrode, a second electrode disposed on the light-emitting layer, and a passivation film disposed on side surfaces of the light-emitting layer, and a portion of the first electrode is disposed on an outer surface of the passivation film.

According to various example embodiments of the present application, the common connection electrode may come into contact with side surfaces of the first electrode.

According to various example embodiments of the present application, a high-potential voltage may be applied through the common connection electrode.

According to various example embodiments of the present application, a planar size of the first electrode may be larger than a planar size of the light-emitting layer.

According to various example embodiments of the present application, an entire area of the light-emitting layer may overlap the first electrode in a thickness direction.

According to various example embodiments of the present application, side surfaces of the first electrode may protrude further outward than an outer surface of the passivation film.

According to various example embodiments of the present application, the first electrode may extend along the outer surface of the passivation film near edges thereof.

According to various example embodiments of the present application, a portion of the passivation film may be disposed between the light-emitting layer and the first electrode.

According to various example embodiments of the present application, the passivation film may be disposed to surround the light-emitting layer along edges of the light-emitting layer.

According to various example embodiments of the present application, the first electrode may come into direct contact with the outer surface of the passivation film.

According to various example embodiments of the present application, the display apparatus may further include an adhesive layer disposed on the substrate, a first insulating layer disposed on the adhesive layer and a second insulating layer disposed on the first insulating layer, in which the first insulating layer and the second insulating layer may cover at least a portion of the light-emitting element, and the second insulating layer may define an opening exposing side surfaces and an upper surface of the second electrode.

According to various example embodiments of the present application, the display apparatus may further include a pixel connection electrode disposed on the second insulating layer, in which the pixel connection electrode may come into contact with the upper surface and side surfaces of the second electrode exposed by the opening.

According to various example embodiments of the present application, the display apparatus may further include a transistor disposed on the substrate, in which the pixel connection electrode may be electrically connected to the transistor.

According to various example embodiments of the present application, the display apparatus may further include a first planarization layer disposed on the transistor; a first connection electrode and a second connection electrode disposed on the first planarization layer, and in which the first connection electrode may be electrically connected to the transistor.

According to various example embodiments of the present application, the display apparatus may further includea second planarization layer disposed on the first connection electrode and the second connection electrode; a third connection electrode and a fourth connection electrode disposed on the second planarization layer, and the third connection electrode may be electrically connected to the first connection electrode, and the fourth connection electrode may be electrically connected to the second connection electrode.

According to various example embodiments of the present application, the adhesive layer, the first insulating layer and the second insulating layer may define a second through-hole exposing the third connection electrode, and the pixel connection electrode may be electrically connected to the third connection electrode exposed by the second through-hole.

According to various example embodiments of the present application, the opening may further expose a portion of the passivation film.

According to various example embodiments of the present application, the display apparatus may further include a pixel connection electrode disposed on the second insulating layer, in which the pixel connection electrode may come into direct contact with the passivation film exposed by the opening.

According to various example embodiments of the present application, the light-emitting layer may comprise: a first semiconductor layer disposed on the first electrode; an active layer disposed on the first semiconductor layer; and a second semiconductor layer disposed on the active layer, and a width of the light-emitting layer decreases from the first semiconductor layer toward the second semiconductor layer.

According to various example embodiments of the present application, side surfaces of the second electrode may be formed to further protrude toward the light-emitting layer than other regions.

According to various example embodiments of the present application, the second electrode may overlap the passivation film in a thickness direction.

According to various example embodiments of the present application, there is provided a display apparatus comprising a substrate, an adhesive layer disposed on the substrate, a light-emitting element disposed on the adhesive layer, in which the light-emitting element includes a first electrode disposed on the adhesive layer, a light-emitting layer disposed on the first electrode, a second electrode disposed on the light-emitting layer, and a passivation film disposed on side surfaces of the light-emitting layer, and an upper surface and side surfaces of the second electrode may be exposed.

According to various example embodiments of the present application, the display apparatus may further comprise a first insulating layer disposed on the adhesive layer and covering a portion of a lower portion of the light-emitting element; a second insulating layer disposed on the first insulating layer; and a common connection electrode disposed between the adhesive layer and the first insulating layer, in which the common connection electrode may come into contact with side surfaces of the first electrode.

According to various example embodiments of the present application, side surfaces of the first electrode may protrude further outward than an outer surface of the passivation film.

According to various example embodiments of the present application, the display apparatus may further comprise a pixel connection electrode disposed on the second insulating layer, in which the second insulating layer may define an opening exposing an upper surface and side surfaces of the second electrode, and the pixel connection electrode may come into contact with the upper surface and side surfaces of the second electrode exposed by the opening.

According to various example embodiments of the present application, a portion of the first electrode may be disposed on the outer surface of the passivation film.

Although various example embodiments have been described above with reference to the accompanying drawings, those skilled in the art to which the present application pertains will be able to understand that the above-described technical configuration can be carried out in other specific forms without changing the technical spirit or essential features thereof. Accordingly, it should be understood that the above-described embodiments are illustrative and not restrictive in all respects. In addition, the scope of various example embodiments is determined by the appended claims rather than detailed description. In addition, the meaning and scope of the claims and all changed or modified forms derived from the equivalent concept thereof should be construed as being included in the scope of various example embodiments.

### DESCRIPTION OF REFERENCE NUMERALS

10: display apparatus
110: substrate
TR: transistor
140: first planarization layer
180: adhesive layer
LD: light-emitting element
210: first electrode
220: active layer
221: first semiconductor layer
222: light-emitting layer
223: second semiconductor layer
230: second electrode
240: passivation film
190: first insulating layer
200: second insulating layer
TH: through-hole
OP: opening

## Claims

1. A display apparatus comprising:
a substrate;
a light-emitting element disposed on the substrate; and
a common connection electrode disposed on the substrate and in contact with the light-emitting element,
wherein the light-emitting element includes:
a first electrode disposed on the substrate;
a light-emitting layer disposed on the first electrode;
a second electrode disposed on the light-emitting layer; and
a passivation film disposed on side surfaces of the light-emitting layer, and
a portion of the first electrode is disposed on an outer surface of the passivation film.

2. The display apparatus of claim 1, wherein the common connection electrode comes into contact with side surfaces of the first electrode; and optionally:
wherein a high-potential voltage is applied through the common connection electrode.

3. The display apparatus of any preceding claim, wherein a planar size of the first electrode is larger than a planar size of the light-emitting layer; and optionally:
wherein an entire area of the light-emitting layer overlaps the first electrode in a thickness direction.

4. The display apparatus of any preceding claim, wherein side surfaces of the first electrode protrude further outward than the outer surface of the passivation film; and optionally:
wherein the first electrode extends along the outer surface of the passivation film near edges thereof.

5. The display apparatus of any preceding claim, wherein a portion of the passivation film is disposed between the light-emitting layer and the first electrode; and optionally:
wherein the passivation film is disposed to surround the light-emitting layer along edges of the light-emitting layer.

6. The display apparatus of any preceding claim, wherein the first electrode comes into direct contact with the outer surface of the passivation film.

7. The display apparatus of any preceding claim, further comprising an adhesive layer disposed on the substrate, a first insulating layer disposed on the adhesive layer and a second insulating layer disposed on the first insulating layer,
wherein the first insulating layer and the second insulating layer cover at least a portion of the light-emitting element, and
the second insulating layer defines an opening exposing side surfaces and an upper surface of the second electrode.

8. The display apparatus of claim 7, further comprising a pixel connection electrode disposed on the second insulating layer,
wherein the pixel connection electrode comes into contact with the upper surface and side surfaces of the second electrode exposed by the opening.

9. The display apparatus of claim 8, further comprising a transistor disposed on the substrate,
wherein the pixel connection electrode is electrically connected to the transistor.

10. The display apparatus of claim 9, further comprising:
a first planarization layer disposed on the transistor;
a first connection electrode and a second connection electrode disposed on the first planarization layer, and
wherein the first connection electrode is electrically connected to the transistor.

11. The display apparatus of claim 10, further comprising:
a second planarization layer disposed on the first connection electrode and the second connection electrode;
a third connection electrode and a fourth connection electrode disposed on the second planarization layer, and
wherein the third connection electrode is electrically connected to the first connection electrode, and the fourth connection electrode is electrically connected to the second connection electrode; and optionally:
wherein the adhesive layer, the first insulating layer and the second insulating layer define a second through-hole exposing the third connection electrode, and the pixel connection electrode is electrically connected to the third connection electrode exposed by the second through-hole.

12. The display apparatus of any one of claims 7 to 11, wherein the opening further exposes a portion of the passivation film; and optionally:
further comprising a pixel connection electrode disposed on the second insulating layer, wherein the pixel connection electrode comes into direct contact with the passivation film exposed by the opening.

13. The display apparatus of any preceding claim, wherein the light-emitting layer comprises:
a first semiconductor layer disposed on the first electrode;
an active layer disposed on the first semiconductor layer; and a second semiconductor layer disposed on the active layer, and
wherein a width of the light-emitting layer decreases from the first semiconductor layer toward the second semiconductor layer.

14. The display apparatus of any preceding claim, wherein side surfaces of the second electrode are formed to further protrude toward the light-emitting layer than other regions.

15. The display apparatus of any preceding claim, wherein the second electrode overlaps the passivation film in a thickness direction.
